# EUROPEAN PATENT APPLICATION

(11) **EP 4 432 281 A1**
(43) Date of publication of application: **18.09.2024**
(21) Application number: 24163627.3
(22) Date of filing: 14.03.2024
(51) Int. Cl.: G11C 5/14, G11C 7/10, G11C 11/417

(54) **DUAL-RAIL MEMORY DEVICE WITH HIGH SPEED AND LOW POWER CONSUMPTION**

(30) Priority: 16.03.2023 US 202363490536 P; 19.02.2024 US 202418444776
(71) Applicant: MediaTek Inc., Hsin-Chu 300 (TW)
(72) Inventor: LIAO, Weinan, 30078 Hsinchu City (TW); HUANG, Jiann-Tseng, 30078 Hsinchu City (TW)
(74) Representative: Haseltine Lake Kempner LLP

(57) **Abstract**

The present invention provides a memory device including a memory array, an IO circuitry and a control circuit. The IO circuitry is configured to access the memory array. The control circuit is configured to generate at least a global IO signal to the IO circuitry, to control operations of the IO circuitry, wherein the IO circuitry is supplied by a first supply voltage, the control circuit is supplied by at least a second supply voltage different from the first supply voltage.

## Description

This application claims the benefit of U.S. Provisional Application No. 63/490,536, filed on March 16th, 2023. The content of the application is incorporated herein by reference.

### Background

A dual-rail static random access memory (SRAM) has been widely used in various chips. The dual-rail SRAM refers to an SRAM arrangement where the logic circuits are operated in a low voltage domain, while the memory array is operated in a high voltage domain. Due to this, the chip area and the power consumption can be reduced but the memory access time or memory access speed is impacted, especially the memory access time will be greatly affected if the SRAM uses an ultra-low supply voltage.

### Summary

It is therefore an objective of the present invention to provide a dual-rail memory device, which can reduce the impact of ultra-low supply voltage on the memory access time while maintaining low power consumption and low chip area, to solve the above-mentioned problems.

According to one embodiment of the present invention, a memory device comprising a memory array, an IO circuitry and a control circuit is disclosed. The IO circuitry is configured to access the memory array. The control circuit is configured to generate at least a global IO signal to the IO circuitry, to control operations of the IO circuitry, wherein the IO circuitry is supplied by a first supply voltage, the control circuit is supplied by at least a second supply voltage different from the first supply voltage.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a memory device according to one embodiment of the present invention.
FIG. 2 is a diagram illustrating the supply voltage configuration of the control circuit according to one embodiment of the present invention.
FIG. 3 is a diagram illustrating the supply voltage configuration of the control circuit according to one embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

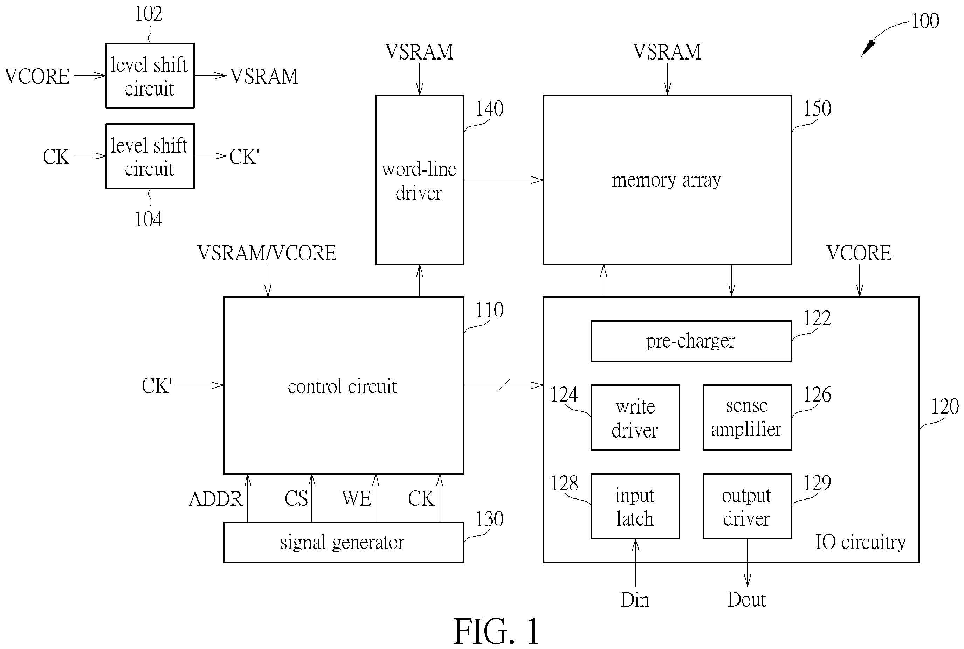

FIG. 1 is a memory device 100 according to one embodiment of the present invention. As shown in FIG. 1, the memory device 100 comprises a control circuit 110, a input/output (IO) circuitry 120, a signal generator 130, a word-line driver 140 and a memory array 150, wherein the IO circuitry 120 comprises at least a pre-charger 122, a write driver 124, a sense amplifier 126, an input latch 128 and an output driver 129. In this embodiment, the memory device 100 is a dual-rail SRAM circuitry, that is the memory device 100 uses supply voltages such as VCORE and VSRAM from different power domains. In addition, the memory array 150 comprises a plurality of SR_AM cells such as 6-transistor (6-T) SRAM cells, 8-T SRAM cells or 10-T SR_AM cells.

In addition, the memory device 100 may comprise one or more level shift circuits such as 102 and 104 configured to increase voltage levels of the received signals. In one embodiment, without limitations of the present invention, the level shift circuit 102 is configured to receive the supply voltage VCORE to generate the supply voltage VSR_AM, and the level shift circuit 104 is configured to receive a clock signal CK to generate a clock signal CK' , wherein the voltage level of the supply voltage VSR_AM is higher than the voltage level of the supply voltage VCORE, and the voltage level of the clock signal CK' is higher than the voltage level of the clock signal CK. In other embodiments, the supply voltage VSR_AM with higher voltage level may be generated by another supply voltage generator, and the clock signal CK' with higher voltage level may be generated by another clock signal generator.

In the operation of the memory device 100, the signal generator 130 is configured to generate multiple signals for use of the control circuit 110, for example, the multiple signals may comprise an address signal ADDR, a chip select signal CS, a write enable signal WE and the clock signal CK. The control circuit 110 may comprise a read/write timing control circuit, an address latch, a column decoder, a row decoder and other circuits, and the control circuit 110 is configured to generate control signals and IO signals to the word-line driver 140 and the IO circuitry 120. The word-line driver 140 is configured to enable the word line of the memory array 150 based on the control signals generated by the control circuit 110. Regarding the IO circuitry 120, the pre-charger 122 is configured to pre-charge bit lines of the memory array 150; the input latch 128 is configured to receive an input data Din from an external circuit; the write driver 124 is configured to receive the input data Din from the input latch 128 to write the input data into the memory array 150; the sense amplifier 126 is configured to read data from the memory array 150; and the output driver 129 is configured to generate output data Dout to the external circuit according to the data read by the sense amplifier 126. It is noted that the basic operations of the components within the memory device 100 are known by a person skilled in the art, and the present invention focuses on the supply voltage configurations of the memory device 100, so the detailed descriptions about the operations of the above components are omitted here.

In this embodiment, the word-line driver 140 and the memory array 150 are supplied by the supply voltage VSR_AM with higher voltage level, so that the memory array 150 has a fast access speed. The IO circuitry 120 and the signal generator 130 are supplied by the supply voltage VCORE with lower voltage level, so that the IO circuitry 120 and the signal generator 130 have lower power consumption and smaller chip area. In addition, the control circuit 110 is supplied by both the supply voltage VCORE and the supply voltage VSRAM, that is the control circuit 110 has a first portion supplied by the supply voltage VCORE and a second portion supplied by the supply voltage VSRAM, so that the control circuit 110 can maintain the signal transmission speed while reducing power consumption.

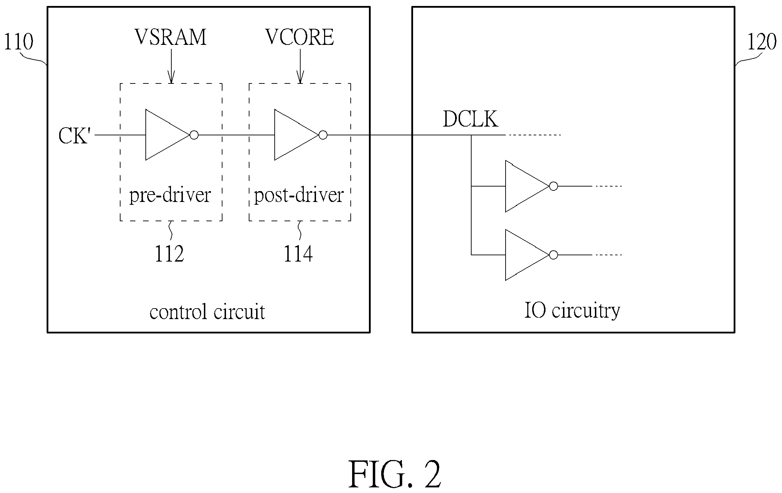

FIG. 2 is a diagram illustrating the supply voltage configuration of the control circuit 110 according to one embodiment of the present invention. As shown in FIG. 2, the control circuit 110 comprises a pre-driver 112 and a post-driver 114, wherein the pre-driver 112 receives a signal to generate a processed signal, and the post-driver 114 receives the processed signal to generate global IO signal to the IO circuitry 120. In this embodiment, without limitations of the present invention, the pre-driver 112 is implemented by using an inverter, and the post-driver 114 is also implemented by an inverter, the clock signal CK' serves as the signal inputted into the pre-driver 112, and an output clock signal DCLK serves as the global IO signal. In other embodiments, the pre-driver 112 may comprise more than one inverters connected in series, and the post-driver 114 may comprise more than one inverters connected in series.

In the embodiment shown in FIG. 2, the pre-driver 112 is supplied by the supply voltage VSR_AM with higher voltage level, and the post-driver 114 is supplied by the supply voltage VCORE with lower voltage level. Because the pre-driver 112 is supplied by the supply voltage VSRAM, an output signal of the pre-driver 112 will have higher voltage level, so that the post-driver 114 can generate the output clock signal DCLK with faster speed. Specifically, when the clock signal CK' has a low voltage level, the output signal of the inverter within the pre-driver 112 will have a high voltage level; and because the output signal of the inverter has the high voltage level such as VSRAM, an N-type transistor within the inverter of the post-driver 114 will be enabled with higher current, so that the post-driver 114 can generate the output clock signal DCLK having the low voltage level (e.g., 0V or ground voltage) in a short time. In addition, because the control circuit 110 generates the output clock signal DCLK with faster speed, a hold time will be shortened when the input latch 128 uses the output clock signal DCLK to sample the input signal Din.

In addition, the output clock signal DCLK is inputted into the IO circuitry 120, for use of the multiple components such as the input latch 128, the output driver 129, the write driver 124 or the sense amplifier 126. That is, the IO circuitry 120 may have multiple paths, such as the inverters shown in FIG. 2, for receiving the output clock signal DCLK.

In the embodiment shown in FIG. 2, the pre-driver 112 receives the clock signal CK' that is generated by level-shifting the clock signal CK. However, in other embodiments, the pre-driver 112 can receive the clock signal CK having lower voltage level.

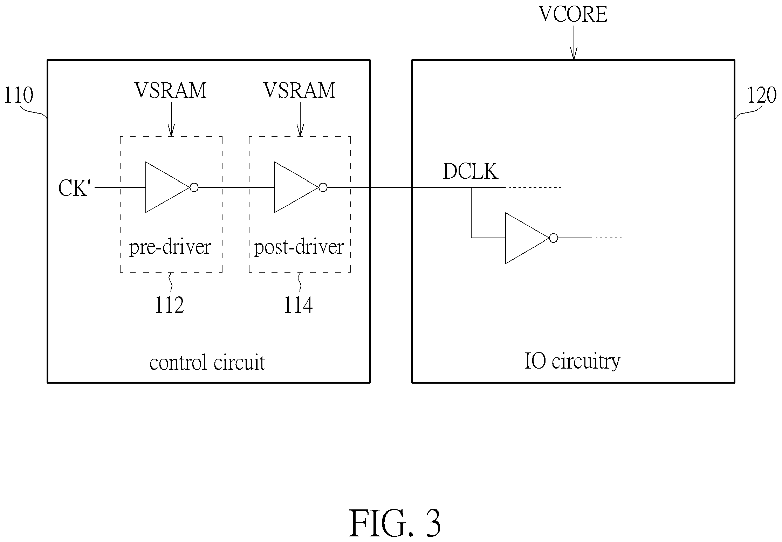

In the above embodiment shown in FIG. 1 and FIG. 2, the pre-driver 112 and the post-driver 114 are supplied by using different supply voltages, however, the present invention is not limited to this. In another embodiment shown in FIG. 3, the pre-driver 112 and the post-driver 114 can be supplied by the same supply voltage VSRAM, or all the components within the control circuit 110 are supplied by the supply voltage VSRAM. These alternative designs shall fall within the scope of the present invention.

Briefly summarized, in the memory device of the present invention, by designing the control circuit and the IO circuitry to use the supply voltages belonging to different power domains, and/or by designing the control circuit to have a first portion using a first supply voltage and a second portion using a second supply voltage, the control circuit can maintain the signal transmission speed while reducing power consumption.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A memory device (100), comprising:
a memory array (150);
an input/output, IO, circuitry (120), configured to access the memory array (150); and
a control circuit (110), configured to generate at least a global IO signal to the IO circuitry (120), to control operations of the IO circuitry (120);
wherein the IO circuitry (120) is supplied by a first supply voltage, the control circuit (110) is supplied by at least a second supply voltage different from the first supply voltage.

2. The memory device (100) of claim 1, wherein the IO circuitry (120) comprises a pre-charger (122), a write driver (124), a sense amplifier (126), an input latch (128) and/or an output driver (129), and the global IO signal is an output clock signal generated by the control circuit (110).

3. The memory device (100) of claim 1, wherein a voltage level of the second supply voltage is higher than a voltage level of the first supply voltage.

4. The memory device (100) of claim 3, further comprising:
a level shift circuit (102, 104), configured to receive the first supply voltage to generate the second supply voltage.

5. The memory device (100) of claim 3, wherein the control circuit (110) is supplied by both the first supply voltage and the second supply voltage.

6. The memory device (100) of claim 5, wherein the control circuit (110) comprises a pre-driver (112) and a post-driver (114), the pre-driver (112) is supplied by the second supply voltage, and the post-driver (114) is supplied by the first supply voltage.

7. The memory device (100) of claim 6, wherein the pre-driver (112) receives a clock signal to generate a processed signal, and the post-driver (114) receives the processed signal to generate an output clock signal serving as the global IO signal to the IO circuitry (120).

8. The memory device (100) of claim 6, further comprising:
a signal generator (130) supplied by the first supply voltage, configured to generate a first clock signal;
a level shift circuit (102, 104), configured to receive the first clock signal to generate the clock signal, wherein a voltage level of the clock signal is higher than a voltage level of the first clock signal.

9. The memory device (100) of claim 6, wherein each of the pre-driver (112) and the post-driver (114) comprises an inverter.

10. The memory device (100) according to any one of the preceding claims, wherein the memory device (100) is a dual-rail static random access memory, SRAM, circuitry.
